# FASCICULE DE BREVET EUROPEEN

(11) **EP 0 572 342 B1**
(45) Date de publication et mention de la délivrance du brevet: **01.12.1999**
(21) Numéro de dépôt: 93470010.5
(22) Date de dépôt: 16.04.1993
(51) Int. Cl.: G03F 7/30

(54) **Procédé automatisé pour la confection de clichés souples et dispositif de mise en oeuvre du procédé**
Automatisches Verfahren zur Herstellung von flexiblen Druckplatten und Gerät zur Ausführung des Verfahrens
Automised process for the production of flexible printing plates and apparatus therefor

(30) Priorité: 25.05.1992 FR 9206537
(43) Date de publication de la demande: 01.12.1993
(73) Titulaire: DU PONT DE NEMOURS (DEUTSCHLAND) GMBH, 63263 Neu-Isenburg (DE); E.I. DUPONT DE NEMOURS AND COMPANY, Wilmington, Delaware 19898 (US)
(72) Inventeur: Ferrante, Mario, F-54520 Laxou (FR); Boucher, Raymond, F-54600 Villers les Nancy (FR)
(74) Mandataire: Hirsch, Marc-Roger

(56) Documents cités:
- DE-A- 1 597 802
- DE-A- 1 805 422
- DE-A- 2 030 539
- US-A- 3 812 514
- US-A- 4 023 229

## Description

La présente invention concerne un procédé pour la confection de clichés souples, utilisables pour la réalisation d'imprimés en flexographie, typographie ou offset sec, elle concerne également un dispositif de mise en oeuvre du procédé.

Plus exactement, l'invention concerne un procédé pour traiter très rapidement des plaques photopolymères de tout format, afin de les transformer en clichés d'impression.

On sait déjà que l'on peut obtenir un cliché pour la flexographie ou la typographie en exposant une plaque de photopolymère sensible aux rayonnements ultraviolets, avec l'interposition d'un film négatif qui laisse exposées au rayonnement les zones qui doivent venir en relief sur le cliché terminé.

Le rayonnement durcit ces zones et on élimine ensuite la matière de la surface protégée en la brossant à l'aide de brosses planes ou rotatives ou par buses de pulvérisation ; un solvant ou de l'eau faisant office d'agent mouillant, on poursuit l'opération jusqu'à ce que les zones qui ont été exposées se trouvent suffisamment en relief.

Un premier objet de l'invention est d'automatiser complètement l'ensemble du procédé de gravure.

Par ailleurs, on trouve actuellement sur le marché une large gamme de plaques photopolymères de toutes épaisseurs et dans tous les formats (jusqu'à 50 x 80 pouces), et on fabrique déjà des machines semi-automatiques sur lesquelles le cliché photopolymère est fixé ou collé sur le plateau porte-cliché et une brosse plane à mouvement orbital, baignant dans un bain de gravure, permet de confectionner des clichés.

Un dispositif avec une telle brosse plane à mouvement orbital est décrit dans DE-A-20 30 539.

DE-A-15 97802 décrit un dispositif et un procédé de nettoyage de plaques photopolymères, dans lequel la plaque à nettoyer est attachée sur la face intérieure du couvercle d'un bac destiné à recevoir un bain d'alcool. Le couvercle est susceptible d'être déplacé dans une direction; dans le bac sont disposées des brosses susceptibles d'être déplacées dans une direction perpendiculaire.

US-A-3 812 514 décrit un appareil pour le nettoyage de plaques de résine photosensible exposées, dans lequel les plaques sont fixées sur un tambour par deux extrémités; autour du tambour sont disposées d'une part des buses de projection d'une solution de nettoyage et des buses de projection d'une solution de rinçage, et d'autre part des lampes à arc de mercure.

Un autre but de l'invention est donc de confectionner des clichés photopolymères de tous formats et épaisseurs, dans une machine simple, permettant d'introduire d'un côté un cliché déja exposé et de récupérer celui ci après gravure, presque sec, dans un minimum de temps.

Pour atteindre ces buts, plusieurs problèmes ont dû être résolus et notamment:
- diminution de la durée de l'opération de gravure;
- maintien automatique du cliché en position de gravure;
- mise du cliché en position de gravure automatiquement.

Conformément à l'invention, le nouveau procédé proposé se caractérise en ce qu'il comporte au moins les étapes suivantes:
- accrochage de la plaque sur un tambour (2),
- descente du tambour et de la plaque, face sensible vers le bas, dans un bac de gravure (12);
- gravure par la résultante d'un mouvement alternatif horizontal de brosses planes et d'un mouvement de va-et-vient du bac de gravure, dans un direction horizontale perpendiculaire à celle des brosses,
la plaque étant maintenue automatiquement en cours de gravure par appui par gravité du tambour sur la plaque.

En outre, il comporte de préférence les étapes préalables suivantes:
- introduction et accrochage de la plaque (0) face sensible tournée vers le haut,
- renversement de la plaque à 180° et mise en place automatique en position de gravure face à graver tounée vers le bas.

Et après gravure, les étapes suivantes :
- relèvement automatique de la plaque (0),
- rinçage et nettoyage automatique de la surface et du dos de la plaque pendant son reversement à 180°,
- transfert et contrôle de la plaque face gravée tournée sur le dessus,
- préséchage.

On comprendra mieux l'invention à l'aide de la description ci-après faite en référence aux figures annexées suivantes :
- **Figure 1** : croquis d'un exemple de réalisation d'un dispositif pour la mise en oeuvre du procédé selon l'invention et montrant la première étape du procédé,
- **Figures 2 à 7** : croquis montrant les étapes suivantes du procédé,
- **Figure 8** : croquis montrant le bac de gravure et les brosses planes.

Le procédé selon l'invention comporte au moins les étapes suivantes :

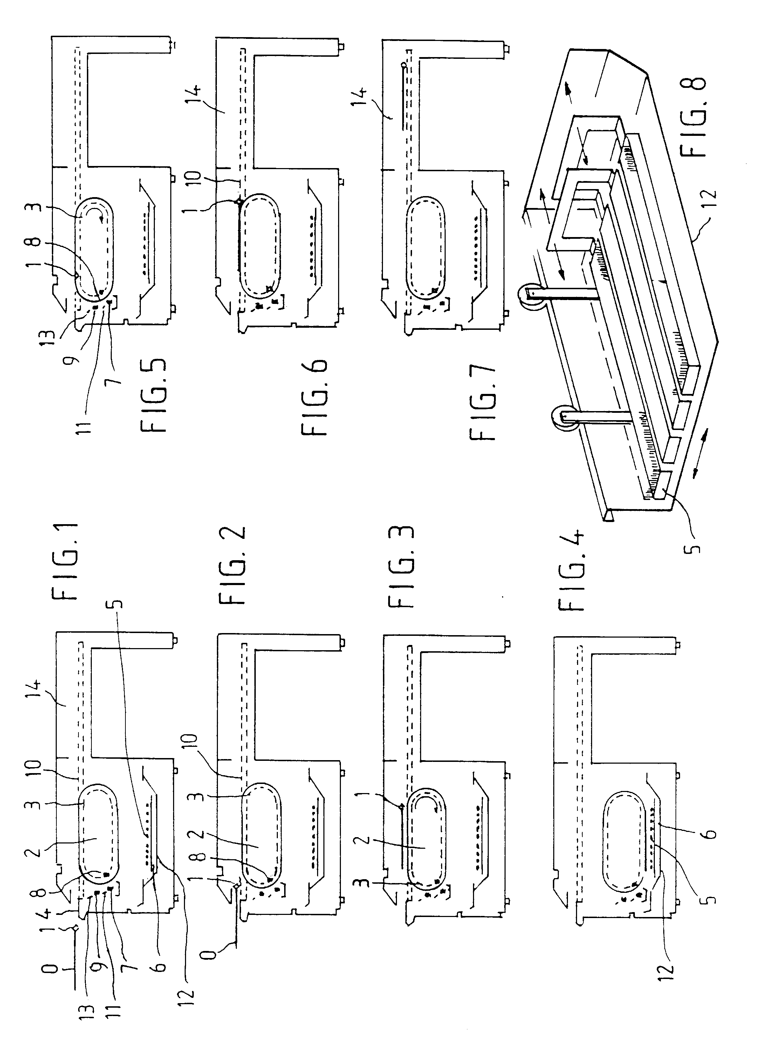

### - Etape de repos (voir figure 1):

Une plaque photopolymère (0), préalablement exposée aux rayons UV, est accrochée sur une barre d'amenage (1) par l'opérateur.

### - Introduction de la plaque (0) (figure 2) :

L'opérateur introduit la barre à l'entrée de la machine sur la table d'entrée.

Il appuie sur un bouton start, en ayant au préalable réglé son temps de gravure sur la minuterie suivant l'épaisseur de la couche photopolymère ainsi que la quantité de solvant de régénération en fonction du creux nécessaire.

### - Renversement de la plaque (0) (figure 3) et mise en place automatique en position de gravure :

La plaque photopolymère est accrochée par une extrémité à une barre (1).

Cette barre est entraînée par exemple à chaque extrémité, par des tétons montés sur la chaîne d'amenage montée sur le tambour flottant au-dessus de la cuve de gravure.

La barre (1) entraîne la plaque photopolymère (0) sur un tambour (2) par l'intermédiaire de chaînes à tétons (3) (figure 3).

La plaque fait le tour du tambour (2) à 180° pour venir se positionner (figure 4) sur la surface des brosses planes (5), elle est alors en position de gravure.

### - Gravure (figures 4 et 8) :

Le tambour (2) descend et vient s'appuyer sur la plaque photopolymère.

Des brosses (5) sont immergées dans le liquide (6).

Le tambour (2) ne bouge pas pendant la gravure. Il appuye simplement sur la plaque photopolymère (0) pendant la gravure par gravité.

Les brosses planes (5), au nombre de quatre, sont espacées entre elles afin de permettre de faire passer le système d'accrochage sur la barre d'amenage (1) et aussi pour permettre au polymère enlevé de se dissoudre ou de s'évacuer très rapidement afin que la gravure se fasse dans les meilleures conditions.

Les brosses (5) planes ont, de plus, un mouvement alternatif l'une par rapport à l'autre, ce qui permet de maintenir le cliché toujours immobile dans sa position initiale (figure 8). A noter que le cliché (0) peut avoir n'importe quelle dimension par rapport au format de la base du tambour (2) et n'importe quelle épaisseur.

Afin d'avoir une gravure uniforme de la surface de la plaque photopolymère, le bac de gravure (12), contenant le liquide (6) et les brosses planes (5), a un mouvement latéral de va-et-vient perpendiculaire à celui des brosses planes (5) comme indiqué figure 8.

La résultante :
- du mouvement alternatif horizontal des brosses planes (5),
- du mouvement de va-et-vient du bac Inférieur (12) dans une direction perpendiculaire horizontale perpendiculaire à celle des brosses,
permet de maintenir la plaque (0) en position fixe sans accrochage autre que la barre et d'avoir un système parfait de gravure selon deux directions orthogonales sur toute surface de n'importe quelle dimension et ceci en une seule fois. Le fait de graver ainsi en une seule fois la totalité de la surface et de placer la plaque photopolymère au-dessus des brosses pour dégager au fur et à mesure le polymère enlevé, permet de résoudre un des problèmes posés, à savoir la rapidité de la gravure.

Le problème du maintient automatique des clichés en position initiale en cours de gravure étant résolu par le mouvement alternatif des brosses planes.

### - Rincage et nettoyage (figure 5) :

Une fois le temps de gravure écoulé, les brosses (5) s'arrêtent : le tambour se soulève et la barre (1) tractée par les chaînes à tétons (3), tire la plaque autour du tambour.

Une brosse rotative (7) baignant dans un bac de liquide propre, viendra rincer la surface de la plaque (0) automatiquement à son passage.

Une brosse rotative (8), baignant dans un bac de liquide propre, viendra rincer le dos de la plaque (0) automatiquement à son passage (figure 5).

Il faut noter que les brosses (7 et 8) s'autonettoyent mutuellement entre elles par frottement lorsqu'il n'y a pas de plaque (0) qui passe.

Une troisième brosse dense (9), mouillée par une rampe de liquide neuf (13) vient essuyer la surface de la plaque (0) au passage (relief de la plaque imprimante).

### - Transfert et contrôle de la plaque (figure 6) :

La barre d'amenage (1) continue son déplacement (figure 6) et elle est prise en charge par la chaîne (10) à tétons qui la transporte dans la section de pré-séchage (14). La plaque peut être contrôlée avant pré-séchange et, en cas de gravure insuffisante l'opérateur a possibilité de réintroduire la plaque dans la section gravure.

### - Pré-séchage, fin de cycle (figure 7) :

En arrivant dans cette chambre de pré-séchage (14), la surface de la plaque est humide, mais aucune goutte de produit ne subsiste sur la plaque (0). Pendant le pré-séchage la chambre est chauffée à 60° environ.

Etant donné que la plaque est restée un temps très court au contact du liquide pendant la gravure, le polymère a absorbé très peu de liquide il n'y a donc pratiquement pas de déformation des traits de l'image et le temps de séchage de la plaque sera très court. La consommation du solvant sera elle aussi réduite en conséquence.

Lorsque la plaque photopolymère arrive dans la section de pré-séchage (14) on peut réintroduire une autre plaque selon l'étape de la figure 1.

Le procédé qui vient d'être décrit permet de graver une face d'une plaque photopolymère préalablement exposée à un rayonnement ultraviolet de n'importe quelle épaisseur et dimension et peut s'appliquer aux domaines de la flexographie, de la typographie, ou de l'offset sec.

Ce procédé offre de nombreux avantages et/ou fonctions particlières et notamment :
- Absence de réglage en hauteur des brosses par rapport à l'épaisseur des plaques photopolymères car la pression de la plaque sur les brosses entre en cause ainsi que le temps de gravure,
- Automatisme complet des étapes,
- Qualité du nettoyage du fait que la plaque est gravée face sensible vers le bas,
- Qualité et rapidité de gravure grâce également à cette position de la plaque sensible car les particules de polymère sont évacuées automatiquement par gravité et au fur et à mesure,
- Gain de temps de gravure à 100 % grâce à la stabilité de la plaque et à la gravure de la surface totale de la plaque en une opération,
- Efficacité du nettoyage-rinçage par la brosse (7) car il s'effectue à la tangeante de deux surfaces arrondies.
- Régénération automatique du liquide (6) dans la cuve (12) par écoulement du liquide de rinçage de la brosse (7),
- Nettoyage automatique des deux brosses (7,8) entre elles par frottement lorsqu'il n'y a pas de plaque qui passe,
- Essuyage superficiel automatique de la plaque par la brosse (9) après le temps de gravure et rinçage,
- Economie de liquide car la brosse (9) est aspergée de liquide propre uniquement avant chaque passage de plaque,
- Retour de la plaque en position initiale après rotation de 360°, ainsi la face gravée est visible pendant le pré-séchage et peut être contrôlée,
- Possibilité de graver toute la surface de la plaque uniformément par la translation alternative de tout l'ensemble inférieur bac et brosses selon une direction perpendiculaire au déplacement des brosses,
- Mise en mouvement du liquide par le fonctionnement aternatif des brosses,
- Passage prévu du système d'accrochage des plaques sur la barre transport (1) grâce à l'écartement des brosses,
- Nettoyage amélioré par la présence d'un râcleur (11) équipant chaque brosse (8,9).
- Possibilité d'adaptation du mouvement de va-et-vient de la cuve perpendiculairement au sens de fonctionnement des brosses,
- Automatisation complète du procédé,
- Machine très compacte et complètement hermétique.

L'invention concerne également un dispositif pour la mise en oeuvre du procédé décrit et comportant non limitativement les moyens cités ci-dessus en particulier d'une part des moyens mécaniques d'entrainement du bac dans un mouvement horizontal de va-et-vient et des moyens mécaniques d'entrainement des brosses planes (5) dans un mouvement alternatif selon une direction horizontale perpendiculaire à celle du bac, et d'autre part des moyens de déposer la plaque (0) par gravité sur les brosses planes (5) face à graver tournée vers lesdites brosses.

En outre, le dispositif comporte de préférence :
- une barre d'amenage (1) comportant des moyens d'accrochage de la plaque,
- des tétons d'entrainement à chaque extrémité de la barre (1) montés sur une chaîne d'amenage montée sur un tambour flottant au dessus du bac de gravure.
- des moyens d'abaissement et relevage du tambour par rapport au bac de gravure.
- une brosse rotative (7) et une brosse rotative (8) baignant dans un bac de liquide propre disposées de façon à effectuer un nettoyage-rincage de la plaque à la tangeante de deux surfaces arrondies.
- une brosse (9) dense rotative mouillée par une rampe de liquide neuf (13) pour l'essuyage de la plaque.
- une chambre de pré-séchage en fin de cycle.

Les brosses planes sont de préférence constituées d'un support en PVC ou polypropylène suivant le type de solution de gravure utilisé. Les diamètres des poils de ces brosses et la densité des touffes sont déterminés suivant le type de photopolymère à graver.

Les barres d'entrainement des plaques photopolymères sont équipées, par exemple, de grenouillères qui permettent d'accrocher simplement et rapidement les plaque de n'importe quelle épaisseur.

Tous les moyens mécaniques d'entrainement des brosses, du bac inférieur (12) et des autres pièces en mouvement peuvent être envisagés.

## Revendications

1. Procédé pour la confection de clichés à partir d'une plaque (0) photopolymère préalablement exposée à un rayonnement ultra-violet afin de les transformer en clichés d'impression pour la flexographie ou la typographie, ou l'offset sec, caractérisé en ce qu'il comprend au moins les étapes de
- accrochage de la plaque sur un tambour (2),
- descente du tambour et de la plaque, face sensible vers le bas, dans un bac de gravure (12);
- gravure par la résultante d'un mouvement alternatif horizontal de brosses planes et d'un mouvement de va-et-vient du bac de gravure, dans une direction horizontale perpendiculaire à celle des brosses,
la plaque étant maintenue automatiquement en cours de gravure par appui par gravité du tambour sur la plaque.

2. Procédé selon la revendication précédente caractérisé en ce qu'il comporte les étapes préalables suivantes:
- introduction et accrochage de la plaque (0) face sensible tournée vers le haut,
- renversement de la plaque à 180° et mise en place automatique en position de gravure face à graver tournée vers le bas.

3. Procédé selon l'une quelconque des revendications précédentes, caractérisé en ce que l'accrochage de la plaque sur le tambour s'effectue par l'intermédiaire d'une barre à l'une des extrémités de la plaque.

4. Procédé selon l'une quelconque des revendications précédentes, caractérisé en ce qu'il comporte après gravure les étapes automatiques suivantes:
- relèvement automatique de la plaque (0),
- rinçage et nettoyage automatique de la surface et du dos de la plaque pendant son renversement à 180°,
- transfert et contrôle de la plaque face gravée tournée vers le dessus,
- préséchage.

5. Dispositif pour la mise en oeuvre du procédé selon l'une des revendications précédentes comportant un bac de gravure (12) contenant le liquide de gravure (6) et des brosses planes (5) caractérisé en ce qu'il comporte
- d'une part des moyens mécaniques d'entraînement du bac dans un mouvement horizontal de va-et-vient et des moyens mécaniques d'entraînement des brosses planes (5) dans un mouvement alternatif selon une direction horizontale perpendiculaire à celle du bac, et d'autre part
- des moyens de déposer la plaque (0) sur les brosses planes (5) face sensible tournée vers lesdites brosses, lesdits moyens de déposer appuyant sur la plaque par gravité lorsque la plaque est déposée sur les brosses.

6. Dispositif selon la revendication 5, caractérisé en ce que les moyens de déposer la plaque comprennent un tambour, et en ce que le dispositif comprend en outre des moyens d'abaissement et de relevage du tambour par rapport au bac de gravure.

7. Dispositif selon la revendication 5 ou 6, caractérisé en ce qu'il comporte en outre:
- une barre d'amenage (1) comportant des moyens d'accrochage de la plaque,
- des tétons d'entraînement à chaque extrémité de la barre (1) montés sur une chaîne d'amenage montée sur un tambour flottant au dessus du bac de gravure.

8. Dispositif selon l'une des revendications 5, 6 et 7, caractérisé en ce qu'il comporte en outre:
- une brosse rotative (7) et une brosse rotative (8) baignant dans un bac de liquide propre disposées de façon à effectuer un nettoyage-rinçage de la plaque à la tangeante de deux surfaces arrondies.
- une brosse (9) dense rotative mouillée par une rampe de liquide neuf (13) pour l'essuyage de la plaque.
- une chambre de pré-séchage en fin de cycle.

## Patentansprüche

1. Ein Verfahren zum Herstellen von Druckplatten aus einer Photopolymerplatte (0), die vorher ultravioletter Strahlung ausgesetzt war zur Umwandlung in Druckplatten für Flexo-, typographischen oder Trockenoffsetdruck, dadurch gekennzeichnet, daß es wenigstens die Schritte beinhaltet:
- Befestigen (engaging) der Platte auf einer Trommel (2),
- Absenken der Trommel und der Platte, mit ihrer empfindlichen Seite nach unten, in einen Auswaschtank (12);
- Auswaschen unter Verwenden der Resultierenden einer horizontalen alternierenden Bewegung der flachen Bürsten und einer hin-und-her Bewegung des Auswaschtanks, in einer Richtung die horizontal und senkrecht zu der der Bürsten ist,
wobei die Platte während des Auswaschens durch die Trommel automatisch am Platz gehalten wird, die durch die Schwerkraft auf der Platte ruht.

2. Das Verfahren nach Anspruch 1, dadurch gekennzeichnet, daß es die folgenden vorhergehenden Schritte enthält:
- Einführen und Befestigen (engagement) der Platte (0) mit seiner empfindlichen Seite nach oben gerichtet,
- drehen der Platte um 180°, um automatisch eine Auswaschposition anzunehmen mit der auszuwaschenden Seite nach unten gerichtet.

3. Das Verfahren nach irgendeinem der vorangehenden Ansprüche, dadurch gekennzeichnet, daß die Platte auf der Trommel durch das Mittel eines Stabs bzw. einer Stange bzw. eines Riegels (bar) an einem Ende der Platte befestigt ist.

4. Das Verfahren nach irgendeinem der vorangehenden Ansprüche, dadurch gekennzeichnet, daß es nach dem Auswaschen die folgenden automatischen Schritte beinhaltet:
- automatisches Anheben der Platte (0),
- automatisches Spülen und Reinigen der Oberfläche und der Rückseite der Platte während ihres Drehens um 180°,
- Transfer und Prüfen der Platte mit der ausgewaschenen Seite davon nach oben gerichtet,
- Vortrocknung.

5. Vorrichtung zum Durchführen des Verfahrens nach irgendeinem der vorangehenden Ansprüche, beinhaltend einen Auswaschtank (12), der eine Auswaschflüssigkeit (6) und flache Bürsten (5) enthält, dadurch gekennzeichnet, daß sie enthält:
- erstens mechanische Mittel zum Bewegen bzw. Antreiben des Tanks in eine horizontale hin-und-her Bewegung und mechanische Mittel zum Bewegen bzw. Antreiben der flachen Bürsten (5) in eine altemierende Bewegung in einer horizontalen Richtung, die senkrecht zu jener des Tanks ist, und zweitens
- Mittel zum Absetzen bzw. Ablegen der Platte (0) auf den flachen Bürsten (5) mit deren empfindlicher Seite zu den Bürsten gerichtet, wobei die Mittel zum Absetzen bzw. Ablegen durch Gravitation auf der Platte ruhen, wenn die Platte auf den Bürsten abgesetzt bzw. abgelegt ist.

6. Vorrichtung nach Anspruch 5, dadurch gekennzeichnet, daß die Mittel zum Absetzen bzw. Ablegen der Platte eine Trommel enthalten, und daß die Vorrichtung zusätzlich Mittel zum Absenken und Anheben der Trommel in Bezug auf den Auswaschtank enthält.

7. Vorrichtung nach irgendeinem der Ansprüche 5 oder 6, dadurch gekennzeichnet, daß sie zusätzlich beinhaltet:
- eine Zuführungsstange bzw. einen -riegel (feed bar) (1) mit Mitteln zum Ineinander- bzw. Eingreifen mit (engaging with) der Platte,
- Antriebsbolzen (drive studs) an jedem Ende des Stabs bzw. der Stange bzw. des Riegels (1), wobei die Bolzen auf einer Vorschubkette montiert sind, die auf einer Trommel montiert ist, die über dem Auswaschtank schwebt.

8. Vorrichtung nach irgendeinem der Ansprüche 5, 6 und 7, dadurch gekennzeichnet, daß sie weiter beinhaltet:
- eine rotierende Bürste (7) und eine rotierende Bürste (8), die in einen Tank mit sauberer Flüssigkeit eintauchen, so angeordnet, daß sie das Reinigen und das Spülen der Platte bei der Tangente zu zwei gerundeten Oberflächen durchführen,
- eine dichte rotierende Bürste (9), die durch eine Vorrichtung mit frischer Flüssigkeit (13) befeuchtete wird, zum Abwischen der Platte,
- eine Kammer zum Durchführen der Vortrockung am Ende des Zyklus.

## Claims

1. A method for preparing printing plates from a photopolymer plate (0) which has been previously exposed to ultraviolet radiation for transformation into printing plates for flexographic, typographic or dry offset printing, characterised in that it comprises at least the steps of:
- engaging said plate on a drum (2),
- lowering the drum and plate, with the sensitive side thereof downwards, into a wash-out tank (12);
- washing-out using the resultant of a horizontal alternating movement of the flat brushes and a to-and-fro movement of the wash-out tank, in a direction that is horizontal and perpendicular to that of the brushes,
the plate being held in place automatically during washing out by the drum resting under gravity on said plate.

2. The method according to claim 1 characterised in that it includes the following prior steps of:
- introduction and engagement of said plate (0) with its sensitive side directed upwardly,
- turning said plate through 180° in order to automatically assume a wash-out position with said side to be washed out directed downwardly.

3. The method according to any one of the preceding claims, characterised in that said plate is engaged on said drum by means of a bar at one extremity of said plate.

4. The method according to any one of the preceding claims, characterised in that it comprises, following washing out, the following automatic steps of:
- automatically raising the plate (0),
- automatically rinsing and cleaning the surface and the back of said plate during its turning through 180°,
- transfer and checking of the plate with the washed-out side thereof directed upwardly,
- pre-drying.

5. Apparatus for carrying out the method according to any one of the preceding
claims comprising a wash-out tank (12) containing a wash-out liquid (6) and flat brushes (5) characterised in that it comprises:
- firstly, mechanical means for driving said tank with a horizontal to-and-fro movement and mechanical means for driving said flat brushes (5) with an alternating movement in a horizontal direction that is perpendicular to that of said tank, and, secondly
- means for depositing said plate (0) on said flat brushes (5) with the sensitive side thereof directed towards said brushes, said depositing means resting on said plate under gravity when said plate is deposited on a said brushes.

6. Apparatus according to claim 5, characterised in that said means for depositing said plate comprise a drum, and in that said apparatus additionally comprises means for lowering and raising said drum with respect to said wash-out tank.

7. Apparatus according to claim 5 or 6, characterised in that it additionally comprises:
- a feed bar (1) having means for engaging with said plate,
- drive studs at each end of said bar (1), said studs being mounted on a feed chain mounted on a drum floating above said wash-out tank.

8. Apparatus according to one of claims 5, 6 and 7, characterised in that it further comprises:
- a rotary brush (7) and a rotary brush (8) dipping into a clean liquid tank arranged so as to perform cleaning and rinsing of said plate at the tangent to two rounded surfaces,
- a dense rotary brush (9) moistened by a fresh liquid boom (13) for wiping said plate,
- a chamber for performing pre-drying at the end of the cycle.
